Europäisches Patentamt

European Patent Office

Office européen des brevets

(19)

(11) Publication number: **0 145 573 B1**

# EUROPEAN PATENT SPECIFICATION

(12)

(45) Date of publication of patent specification: **19.06.91**   (51) Int. Cl.⁵: **H01L 21/76**

(21) Application number: **84402389.5**

(22) Date of filing: **23.11.84**

(54) A method for fabricating a dielectric-isolated integrated circuit device.

(30) Priority: **30.11.83 JP 227263/83**
**30.11.83 JP 227262/83**

(43) Date of publication of application:
**19.06.85 Bulletin 85/25**

(45) Publication of the grant of the patent:
**19.06.91 Bulletin 91/25**

(84) Designated Contracting States:
**DE FR GB**

(56) References cited:
**EP-A- 0 011 443**
**DE-A- 2 451 861**

**PATENT ABSTRACTS OF JAPAN, vol. 8, no.
103 (E-244)[1540], 15th May 1984; & JP-A-59
18 654**

**PATENT ABSTRACTS OF JAPAN, vol. 8, no.
221 (E-271)[1658], 9th October 1984; & JP-
A-59 104 139**

(73) Proprietor: **FUJITSU LIMITED**
**1015, Kamikodanaka Nakahara-ku
Kawasaki-shi Kanagawa 211(JP)**

(72) Inventor: **Ishikawa, Tamotsu**
**21-703, Wakabadai 4 Chome
Asahi-ku Yokohama-shi Kanagawa 241(JP)**
Inventor: **Tanaka, Hirokazu**
**1308, Shomokodanaka Nakahara-ku
Kawasaki-shi Kanagawa 211(JP)**
Inventor: **Tabata, Akira**
**145-7, Iriya 2 Chome Zama-shi
Kanagawa 228(JP)**

(74) Representative: **Descourtieux, Philippe et al
CABINET BEAU de LOMENIE 55 rue
d'Amsterdam
F-75008 Paris(FR)**

## Description

BACKGROUND OF THE INVENTION

The present invention relates to a method for fabricating a dielectric-isolated (DI) integrated circuit (IC) device. It relates more particularly to a method for fabricating an improved DI substrate so as to remove inherent drawbacks associated with its fabricating process.

The use of dielectric isolation (DI) instead of pn-junction isolation in the fabrication of IC devices becomes progressively widespread in specific fields. Due to their reduced parasitic capacitance and very high inter-device breakdown voltage, the DI IC devices are widely used for apparatus where breakdown damage may occur, such as switching devices for subscriber line interface circuits (SLIC) of electronic telephone exchangers.

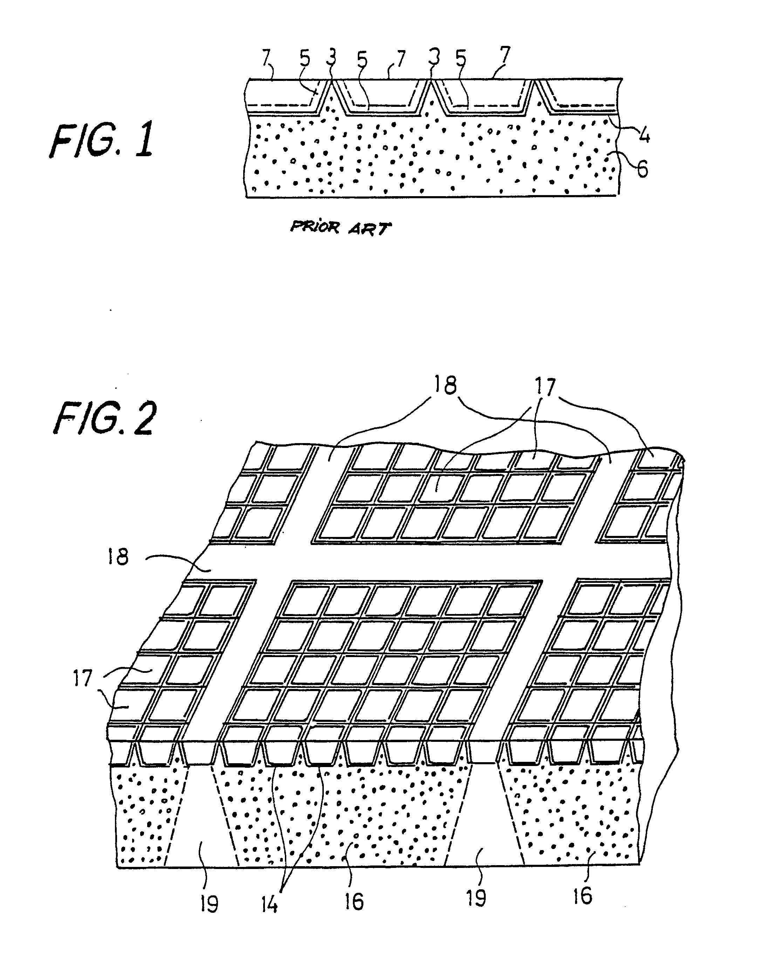

Dielectric isolation is a method for fabricating IC in which circuit components are isolated by dielectric layers. Fig. 1 is a partial cross-sectional view of a prior art DI semiconductor substrate. There are electrical element regions 7 or "islands", isolated from each other and from a substrate 6 by individual dielectric layers 4, usually a silicon dioxide ($SiO_2$) layer. The substrate 6 has a thickness sufficient to support the islands and to ensure the necessary mechanical strength for the device to be handled. The prior art fabrication of a DI wafer begins with preparing a one-conductivity type doped single crystal silicon substrate (original silicon substrate), followed by the formation of insulating moats 3 for islands 7 on the surface. Subsequently, a dielectric layer such as a $SiO_2$ layer 4 is formed covering the entire surface of the wafer, over which silicon is deposited by a conventional chemical vapor deposition (CVD) method using a silicon halide-hydrogen reduction process, to form a layer of a predetermined thickness. The deposited silicon layer is grown at high temperature such as $1100^\circ C$ to form a polycrystalline silicon (polysilicon) layer. The wafer is then inverted and the original single crystal silicon layer is ground enough to reveal the DI layers 4 for the islands 7. Finally the front surface of the wafer is finished to a smooth defect-free surface ready for further fabrication of electrical circuits thereon.(The above process can be understood more easily by observing Fig. 1 upside down. Fig. 1 shows a substrate after the above processes are completed.)

Usually, each island 7 accomodates a circuit element such as a transistor or a film resistor. The island contains a one-conductivity single crystal silicon layer where the circuit element is formed. A heavily doped layer 5 is included to reduce the saturation resistance of the collector of a transistor formed in the island 7.

There are substantial problems in the fabrication of the DI substrate. One of them is the "bow" phenomenon, consisting in the warpage or curvature of the multi-layer structure of the wafer after the formation of the polysilicon substrate layer 6 on the dielectric layer covering the original silicon substrate. There is a difference of expansion coefficient between single crystal silicon and polysilicon. The polysilicon layer is grown at high temperature and the wafer is cooled to room temperature, causing stresses inside said wafer which cause the structure to "bow". Another problem occurs when some humps or projections of coarse structure of polysilicon, formed in the peripheral edge of the wafer, are mechanically removed. Tiny broken pieces of polysilicon mechanically cause damages to the surface of the wafer during surface grinding process, reducing the wafer yield. Furthermore, channels for scribing formed on the DI wafer are covered with the dielectric layer, in the same way as other island areas. Accordingly, scribing cutters are easily abraded when cutting the hard dielectric layer. These are problems associated with the prior art method for fabricating a DI substrate.

SUMMARY OF THE INVENTION

It is an object of the present invention to provide an improved method for fabricating a dielectric isolated (DI) IC device.

It is another object of the present invention to provide a method for fabricating a DI substrate effective in raising the fabrication yield and reducing the fabricating cost of the DI substrate.

These objects are attained by a method which comprises, according to the invention, the steps consisting in :

(a) preparing a one in conductivity type doped single crystal silicon wafer having a surface including a peripheral region which extends along the edge of said wafer, and an interior region;

(b) forming isolation moats within said interior region of the surface of said wafer, which isolate areas wherein electrical circuit elements are formed in a subsequent step;

(c) forming a dielectric isolation layer on a first portion of the interior region of the surface of said wafer, said first portion of the surface including said areas;

(d) exposing said peripheral region of the surface of said wafer, while leaving said first portion of the surface covered by said dielectric isolation layer;

(e) growing a silicon layer on the entire surface of said wafer, wherein said grown silicon layer comprises single crystal silicon over said peripheral region of said surface and polysilicon over said first portion of said surface; and

(f) shaping and rounding the peripheral edge of said wafer.

In document DE-A-2 451 861 is described a method for forming monosilicon zones between polysilicon zones which correspond to moats isolating islands in an IC device. It is pointed out that the formation of monosilicon zones between isolated islands of an IC device or in scribing regions between ICs on a wafer does not form part of the present invention.

As stated hereinbefore, problems are encountered when fabricating a DI substrate by a method according to the prior art, and it will be understood by those skilled in the art that these problems are caused by the polysilicon substrate 6. Therefore, the formation of polysilicon structure for said substrate is not desirable. However, as long as the silicon deposition for forming said substrate is performed on a dielectric layer, the formation of the polysilicon structure is inevitable. A single crystal silicon structure is only obtained by depositing silicon on an exposed single crystal silicon surface. The dielectric layer is indispensable only to island areas, and areas for mounting circuit elements, but unnecessary for other areas such as scribing channel areas, the peripheral area including the edge portion of the wafer and a contact area for the substrate.

With the method according to the invention, for the regions other than the island regions, the formation of the dielectric layer is prevented using for example a conventional masking technology, leaving exposed portions of the original single crystal silicon surface. For example, the formation of the dielectric layer is selectively prevented over the areas for scribing channels, the peripheral area of the wafer and a contact area for the polysilicon substrate so as to expose the original single crystal silicon surface. As a result, single crystal silicon layers are formed selectively and partially over the areas described above, amongst the polysilicon layer.

With thus formed DI substrates, the above mentioned drawbacks can be eliminated or at least reduced. The mismatching effect of the expansion co-efficients of single crystal silicon and polysilicon is limited to the dice which are much smaller than the whole wafer, resulting in the reduction of the "bow" phenomenon, or warpage of the wafer.

During the mechanical processing, such as grinding work for shaping or rounding the peripheral area or edge of the wafer, the generation of destructive polysilicon particles is reduced, because the machining is effected on a portion of single crystal silicon. And, when the wafer is scribed into a number of dice, it can be easily cut along predetermined scribing regions (channels), since an abrasive dielectric layer such as silicon dioxide does not exist therein and harmful polysilicon particles are not generated, resulting in the reduction of the wear of the scribing cutters. Furthermore, the single crystal silicon is easily scribed along its cleavage plane, providing the die with smoother side walls than when scribing a polysilicon substrate.

This method is also applicable to form a contact for the polysilicon substrate, on the front surface of the die, enabling an easy connection of the substrate to a fixed potential. Embodiments of the present invention will now be disclosed with reference to the accompanying drawings.

BRIEF DESCRIPTION OF THE DRAWINGS

Fig. 1 is a cross-sectional view illustrating a structure of islands of a prior art dielectric isolation (DI) IC device.

Fig. 2 is a perspective view, including a partial cross-section, showing the structure of a DI wafer having monosilicon zones formed along scribing channels.

Figs. 3 to 10 are partial cross-sectional views of a DI wafer showing the structure at respective steps for fabricating an IC device:

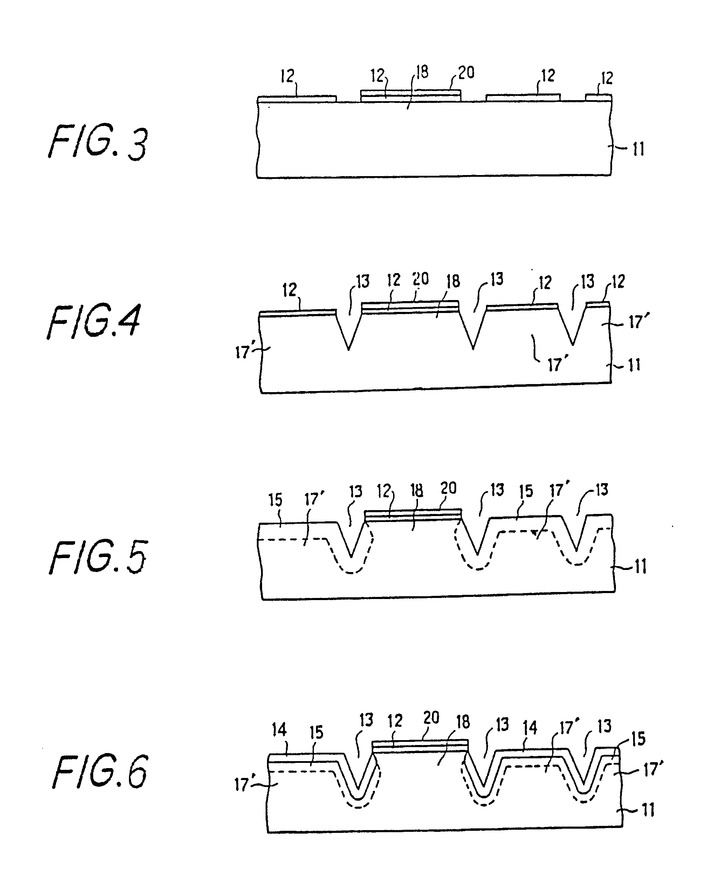

Fig. 3 is a cross-sectional view of the DI wafer after the formation of a thin silicon dioxide layer and a silicon nitride layer over a single crystal substrate,

Fig. 4 is a cross-sectional view of the DI wafer after the formation of isolation moats,

Fig. 5 is a cross-sectional view of the DI wafer after the formation of a heavily doped region in the original single crystal silicon substrate,

Fig. 6 is a cross-sectional view of the DI wafer after the formation of a thick silicon dioxide layer for isolation,

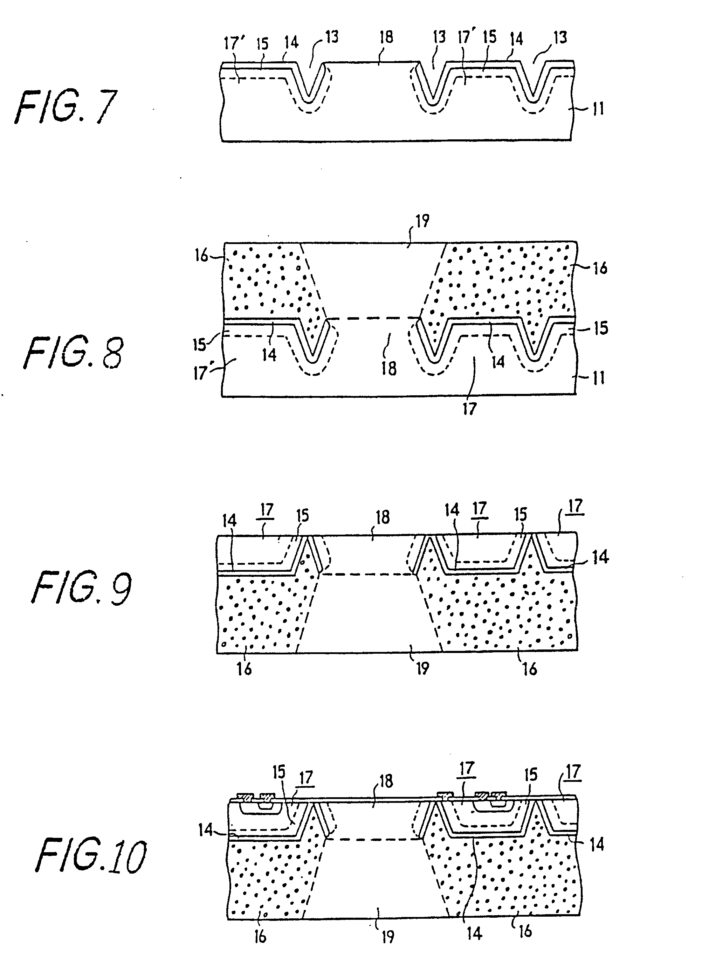

Fig. 7 is a cross-sectional view of the DI wafer after the removal of the thin silicon dioxide layer at areas which are to be scribing regions,

Fig. 8 is a cross-sectional view of the DI wafer after depositing silicon on the inverted device to form a substrate comprising polysilicon portions and single crystal silicon portions,

Fig. 9 is a cross-sectional view of the DI wafer reversed after grinding off the original single crystal silicon substrate to reveal islands,

Fig. 10 is a cross-sectional view of the DI wafer after the formation of circuit elements on the wafer.

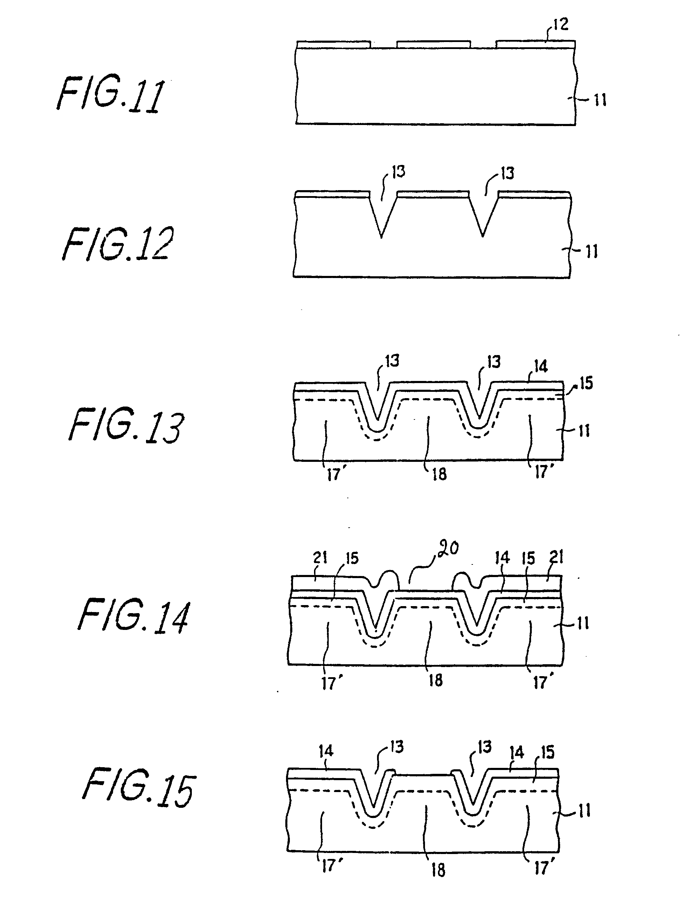

Fig. 11 to 15 are cross-sectional views showing the structure of the wafer at respective steps for fabricating an IC device:

Fig. 11 is a cross-sectional view of the DI wafer after the formation of a silicon dioxide layer on an original single crystal silicon substrate,

Fig. 12 is a cross-sectional view of the DI wafer after the formation of isolation moats,

Fig. 13 is a cross-sectional view of the DI wafer after the formation of a thick silicon dioxide layer for isolation,

Fig. 14 is a cross-sectional view of the DI wafer after the formation of a photoresist layer having windows opened over the scribing regions,

Fig. 15 is a cross-sectional view of the DI wafer after exposing surfaces of the original single crystal silicon substrate.

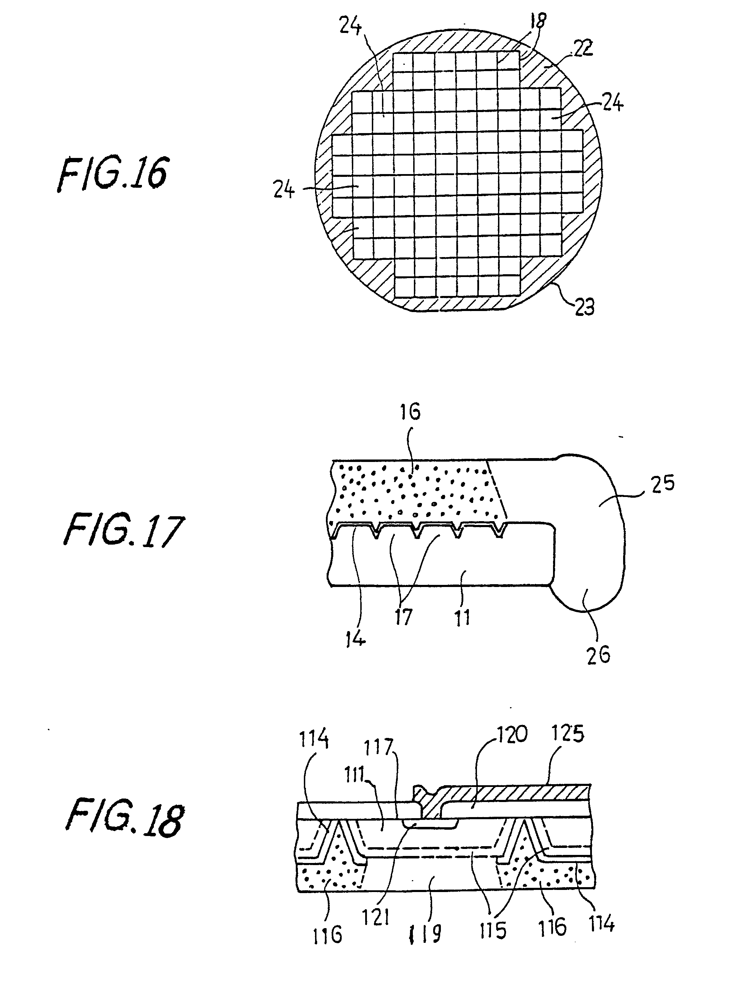

Fig. 16 is a plan view illustrating the configuration of the peripheral region on a DI wafer obtained according to the invention,

Fig. 17 is a cross-sectional view of the DI wafer after the deposition of silicon on the original substrate covered by an isolation layer, illustrating the structure of the deposited silicon layer.

Fig. 18 is a cross-sectional view of a DI wafer having a contact for a polysilicon wafer.

## DESCRIPTION OF THE PREFERRED EMBODIMENTS

Fig. 2 is a perspective view, partially in cross-section, of a portion of a DI wafer fabricated by a method according to the present invention. It should be noted that single crystal silicon layers 19 are selectively formed inside a polysilicon substrate 16 beneath scribing channels 18.

The fabrication steps of this DI substrate are disclosed with reference to Figs. 3 to 10. A one-conductivity type, n-type doped, for instance, single crystal silicon wafer 11 is prepared, followed by the subsequent forming of a silicon dioxide ($SiO_2$) layer 12 over the surface of the wafer 11, leaving windows for isolating moats 13 as shown in Fig. 4, by the use of a conventional lithographic technology. The isolation moats 13 define the island areas as will be seen later. Then, a silicon nitride ($Si_3N_4$) layer 20 is formed selectively over the portion of the $SiO_2$ layer 12 corresponding to the scribing regions 18 by the use of a conventional method. Next, the isolation moats 13 are created by anisotropic etching through the windows, resulting in moats 13 having a V shaped cross-section. After removing the $SiO_2$ layer 12, except for the portion under the silicon nitride layer 20, by etching, a heavily doped, $n^+$ type silicon layer 15 is formed over the entire surface of the wafer by a conventional method as shown in Fig. 5. Following this step, a thermal oxide layer 14 is grown over the entire surface of the wafer except the region covered by the silicon nitride layer 20 as shown in Fig. 6. The thermal oxidation is performed in a pressurized environment of for example 5 atm. The silicon oxide layer 14 forms the isolation layer between the single crystal silicon layer 11 and a polysilicon layer which is to be created later. The thickness of the oxide layer 14 is relatively high, such as 1.0 $\mu$m or more, while that of the silicon dioxide layer 12 formed at the earlier step is relatively low, such as approximately 0.4 $\mu$m (4000 Å). After removing the silicon nitride layer 20 by etching with phosphoric acid, a controlled etching is applied to the entire surface of the wafer, until the thin oxide layer 12 is completely removed to expose the underlying single crystal silicon surface 18 where a scribing region is to be formed. However, as shown in Fig. 7, the thick oxide layer 14 having a predetermined thickness still remains, covering the area 17' where the islands are to be formed and the surfaces of the isolation moats 13.

Subsequently, as shown in Fig. 8, a silicon layer is grown over the entire surface of the substrate, comprising the surface of the oxide layer 14 and the exposed single crystal silicon surface 18, by a conventional CVD method, using a silicon halide such as trichlor silane ($SiHCl_3$). Naturally, a single crystal silicon portion 19 is grown over the surface 18 and a polycrystalline silicon portion 16 is grown over the silicon dioxide layer 14. Following the formation of the substrate layers 16 and 19, the device is inverted and the original single crystal silicon layer 11 is ground off mechanically until the silicon dioxide layers 14 covering the side walls of the moats 13 are revealed on the ground surface as shown in Fig. 9. At this step, the islands 17 are isolated from each other by the silicon dioxide layers 14 as clearly seen in Fig. 9. Thus, a DI wafer is completed. As shown in Fig. 10, using a conventional method, an IC circuit element is created in each island of the completed wafer, which is divided into dice by scribing at the scribing regions 18 comprising single crystal silicon only. Therefore, the scribing tool used, usually a diamond cutter, is not as easily damaged as when used for scribing prior art wafers. In addition, the side walls of each die are smooth and clean since the single crystal silicon is fractured along a cleavage plane.

Another embodiment will now be disclosed referring to Figs. 11 to 15. The modification lies in the method for exposing the surface of the original single crystal silicon layer 11, as shown in Fig. 7 or 15, a photoresist layer being used. A single crystal, substrate 11 is masked with a silicon dioxide layer 12 patterned by a conventional photolithographic technology for opening windows for the moats 13 as shown in Fig. 11. Isolation moats 13 having a V shaped cross-section are formed in the same way as in the former embodiment, as shown in Fig. 12, followed by the formation of heavily doped n-type layer 15 and thick oxide layer 14, consecutively, as shown in Fig. 13. After this step, a photoresist layer 21 is formed over the surface of the oxide layer 14, selectively opening windows 20 for the scribing regions by using a conventional photolithographic technology (Fig. 14). By etching off the thick oxide layer 14 through the windows 20, the areas where the scribing regions are to be formed, on the surface of the original single crystal silicon substrate 11, are exposed as shown in Fig. 15, after which, the photoresist layer 21 is removed by chemical etching or dry etching. The subsequent fabricating steps are the same as in the case of the former embodiment described.

The method for forming a single crystal silicon portion in a polysilicon substrate can be applied to a peripheral region 22 of the wafer, which is denoted by a hatched area in Fig. 16. As illustrated in this Figure, the wafer comprises dice 24 and a peripheral region 22. The dice 24 are separated from one another by cutting the wafer at the scribing regions 18. During the scribing, the scribing tool, such as a cutting grinder, is not abraded as easily as in a prior art method, since the material of the scribing region is single crystal silicon. Usually, when a polysilicon layer is formed on the oxide layer 14, it has many humps 25 and projections 26 of coarse grain immediately after its formation by a CVD method, as shown in Fig. 17. Therefore, it is necessary to shape and round the edge 23 and the peripheral region 22 of the wafer, for a precise working in the subsequent fabrication steps. In this case, a great number of hard and sharp particles are generated, causing damages such as scratches at the surface of the wafer. When the peripheral region 22 including the edge 23 of the wafer is of single crystal silicon, this drawback is significantly decreased, since the workability of the single crystal silicon is much better than that of polysilicon. Accordingly, it is very advantageous for the fabricating process of a DI wafer to apply the method of this invention to obtain a peripheral region 22 of single crystal silicon.

The "bow" phenomenon previously described, still exists in the wafer fabricated according to the method of this invention, as long as a sandwich structure remains at each island. However, the effect of the discrepancy of the expansion coefficient between single crystal silicon and polycrystalline silicon is limited within each island since the scribing regions are constituted entirely of single crystal silicon and that no stress occurs inside these regions.

As a result, the total quantity of "bow", or warpage, is significantly reduced compared to a prior art wafer, providing a greater facility for subsequent machining work of the wafer, for obtaining a precise parallelism of the front and back surfaces of said wafer.

Furthermore, the present invention is applicable to the formation of a contact of a DI IC device with a substrate, for providing said substrate with a fixed electric potential in order to prevent electrical floating, particularly for high frequency use. A cross-sectional view of such contact with the substrate is illustrated in Fig. 18. In a substrate of polysilicon 116, islands 117 are formed using the method described above. In this case, one of islands 117 is modified to form a contact with the substrate 116. The bottom portion of a dielectric isolation layer 114 is removed to expose a surface of single crystal silicon, before the formation of the polysilicon substrate by a CVD method, and with the aid of the exposed surface of the original single crystal silicon substrate 111, a portion 119 of single crystal silicon is formed in the polysilicon layer 116. The fabrication process will be apparent for those skilled in the art with reference to the preceding description regarding embodiments of the present invention. A heavily doped layer 115 is not necessary but neither harmful for the contact and can be formed simultaneously with doped layers 115 for other islands 117. After completion of the DI substrate, a silicon dioxide layer 120, an n$^+$ type doped contact-region 121 and a wiring 125 are formed by a conventional method as shown in Fig. 18. In this case, the formation of the wiring 125 can be performed together with other wirings for circuit elements formed on islands, resulting in a saving of fabricating steps.

**Claims**

1. A method of fabricating a dielectric isolation (DI) integrated circuit device comprising the steps of:

(a) preparing a one conductivity type doped single crystal silicon wafer having a surface including a peripheral region which extends along the edge of said wafer, and an interior region;

(b) forming isolation moats within said interior region of the surface of said wafer, which isolate areas wherein electrical circuit elements are formed in a subsequent step;

(c) forming a dielectric isolation layer on a first portion of the interior region of the surface of said wafer, said first portion of the surface including said areas;

(d) exposing said peripheral region of the surface of said wafer, while leaving said first portion of the surface covered by said dielectric isolation layer;

(e) growing a silicon layer on the entire surface of said wafer, wherein said grown silicon layer comprises single crystal silicon over said peripheral region of said surface and polysilicon over said first portion of said surface; and

(f) shaping and rounding the peripheral edge of said wafer.

2.  A method of fabricating a dielectric isolation (DI) integrated circuit device as set forth in claim 1, wherein said dielectric isolation layer is a silicon dioxide ($SiO_2$) layer.

3.  A method of fabricating a dielectric isolation (DI) integrated circuit device as set forth in claim 1, wherein preparing said wafer comprises the steps of :

    (a) forming a silicon dioxide layer on the surface of said doped silicon wafer, said silicon dioxide layer having windows at predetermined locations therein;

    (b) forming a silicon nitride ($Si_3N_4$) layer on predetermined portions of said silicon dioxide layer; and

    (c) wherein said moats are formed in the areas beneath the windows in said silicon dioxide layer.

4.  A method of fabricating a dielectric isolation (DI) integrated circuit device as set forth in claim 3, wherein exposing said peripheral region of the surface comprises removing said predetermined portions of said silicon dioxide layer and said silicon nitride layer.

**Revendications**

1.  Procédé de fabrication d'un dispositif à circuit intégré à isolation par diélectrique (DI), comprenant les opérations suivantes :

    (a) préparer une pastille de silicium monocristallin dopé suivant un premier type de conductivité, qui possède une surface comportant une région périphérique, qui s'étend le long du bord de ladite pastille, et une région intérieure ;

    (b) former des fosses d'isolation a l'intérieur de ladite région intérieure de la surface de ladite pastille, lesquelles isolent des aires dans lesquelles des éléments de circuit électriques seront formés lors d'une opération ultérieure ;

    (c) former une couche d'isolation par diélectrique sur une première partie de la région intérieure de la surface de ladite pastille, ladite première partie de la surface comportant lesdites aires ;

    (d) exposer ladite région périphérique de la surface de la pastille, tout en laissant ladite première partie de la surface recouverte par ladite couche d'isolation par diélectrique ;

    (e) faire croître une couche de silicium sur toute la surface de ladite pastille, ladite couche de silicium que l'on fait croître comprenant du silicium monocristallin sur ladite région périphérique de ladite surface et du silicium polycristallin sur ladite première partie de ladite surface ; et

    (f) conformer et arrondir le bord périphérique de ladite pastille.

2.  Procédé de fabrication d'un dispositif à circuit intégré à isolation par diélectrique (DI) selon la revendication 1, où ladite couche d'isolation par diélectrique est une couche de dioxyde de silicium ($SiO_2$).

3.  Procédé de fabrication d'un dispositif a circuit intégré à isolation par diélectrique (DI) selon la revendication 1, où la préparation de ladite pastille comprend les opérations suivantes :

    (a) former une couche de dioxyde de silicium sur la surface de ladite pastille de silicium dopé, ladite couche de dioxyde de silicium comportant des fenêtres en des emplacements prédéterminés ;

    (b) former une couche de nitrure de silicium ($Si_3N_4$) sur des parties prédéterminées de ladite couche de dioxyde de silicium ; et

    (c) où lesdites fosses sont formées dans les aires situées au-dessous des fenêtres dans ladite couche de dioxyde de silicium.

4.  Procédé de fabrication d'un dispositif à circuit intégré à isolation par diélectrique (DI) selon la revendication 3, où l'exposition de ladite région périphérique de la surface consiste à enlever lesdites parties prédéterminées de ladite couche de dioxyde de silicium et de ladite couche de nitrure de silicium.

**Ansprüche**

1.  Verfahren zur Herstellung einer integrierten Schaltungsvorrichtung mit dieelektrischer Isolation (DI) mit den folgenden Schritten:

    (a) Präparieren eines dotierten, einkristallinen Siliciumwafers von einem Leitfähigkeitstyp, der eine Oberfläche hat, die ein peripheres Gebiet, das sich längs dem Rand des genannten Wafers erstreckt, und ein inneres Gebiet einschließt;

    (b) Bilden von Isolationsgräben innerhalb des genannten inneren Gebiets der Oberfläche des genannten Wafers, welche Bereiche isolieren, in denen bei einem folgenden Schritt elektrische Elemente gebildet werden;

    (c) Bilden einer dieelektrischen Isolationsschicht auf einem ersten Abschnitt des inneren Gebiets der Oberfläche des genannten Wafers, welcher genannte erste Abschnitt der Oberfläche die genannten Bereiche enthält;

(d) Exponieren des genannten peripheren Gebiets der Oberfläche des genannten Wafers, wobei der genannte erste Abschnitt der Oberfläche durch die genannte dieelektrische Isolationsschicht bedeckt gelassen wird;

(e) Aufwachsen einer Siliciumschicht auf der gesamten Oberfläche des genannten Wafers, wobei die genannte aufgewachsene Siliciumschicht einkristallines Silicium über dem genannten peripheren Gebiet der genannten Oberfläche und Polysilicium über dem genannten ersten Abschnitt der genannten Oberfläche umfaßt; und

(f) Formen und Abrunden des peripheren Randes des genannten Wafers.

2. Verfahren zur Herstellung einer integrierten Schaltungsvorrichtung mit dieelektrischer Isolation (DI) nach Anspruch 1, bei dem die genannte dielektrische Isolationsschicht eine Siliciumdioxid-(SiO$_2$)-Schicht ist.

3. Verfahren zur Herstellung einer integrierten Schaltungsvorrichtung mit dieelektrischer Isolation (DI) nach Anspruch 1, bei dem das Präparieren des Wafers die folgenden Schritte umfaßt:

(a) Bilden einer Siliciumdioxidschicht auf der Oberfläche des dotierten Siliciumwafers, welche Siliciumdioxidschicht an vorbestimmten Orten darin Fenster hat;

(b) Bilden einer Siliciumnitrid-(Si$_3$N$_4$)-Schicht auf den vorbestimmten Abschnitten der genannten Siliciumdioxidschicht; und

(c) bei dem die genannten Gräben in Bereichen unterhalb der Fenster in der genannten Siliciumdioxidschicht gebildet werden.

4. Verfahren zur Herstellung einer integrierten Schaltungsvorrichtung mit dieelektrischer Isolation (DI) nach Anspruch 3, bei dem das Exponieren des genannten peripheren Gebiets der Oberfläche die Entfernung der genannten vorbestimmten Abschnitte der genannten Siliciumdioxidschicht und der genannten Siliciumnitridschicht umfaßt.

*FIG. 1*

PRIOR ART

*FIG. 2*

FIG. 3

FIG.4

FIG.5

FIG.6

FIG. 7

FIG. 8

FIG. 9

FIG. 10

FIG.11

FIG.12

FIG.13

FIG.14

FIG.15

FIG.16

FIG.17

FIG.18